# EUROPEAN PATENT APPLICATION

(11) **EP 3 214 658 A1**
(43) Date of publication of application: **06.09.2017**
(21) Application number: 15854343.9
(22) Date of filing: 24.09.2015
(51) Int. Cl.: H01L 31/048

(54) **METHOD FOR MANUFACTURING SOLAR CELL MODULE AND APPARATUS FOR MANUFACTURING SOLAR CELL MODULE**

(30) Priority: 27.10.2014 JP 2014218584
(71) Applicant: Panasonic Intellectual Property Management Co., Ltd., Osaka-shi, Osaka 540-6207 (JP)
(72) Inventor: OGAWA, Keisuke, Osaka-shi, Osaka 540-6207 (JP); IMADA, Naoto, Osaka-shi, Osaka 540-6207 (JP); KANNO, Hiroshi, Osaka-shi, Osaka 540-6207 (JP)
(74) Representative: Müller-Boré & Partner Patentanwälte PartG mbB
(86) International application number: PCT/JP2015/004833
(87) International publication number: WO 2016/067516

(57) **Abstract**

A method for manufacturing a solar cell module comprises: a step for manufacturing a multilayer 16 by stacking and heat-pressing solar cells 11, an encapsulantl4, and protection members; a heat treatment step for heating the entire multilayer 16 and, after the heating ends, cooling the multilayer16 to a prescribed temperature; and a light radiation step for radiating light with a maximum peak wavelength of 1500 nm onto the solar cells 11 of the multilayer 16, thereby heating the encapsulant 14 as a result of an increase in the temperature of the solar cells, such that the temperatures of the solar cells 11 and the encapsulant 14 constituting the multilayer 16 do not exceed the respective maximum temperatures thereof in at least the heat treatment step.

## Description

### TECHNICAL FIELD

The present disclosure relates to a method for manufacturing a solar cell module, and an apparatus for manufacturing a solar cell module.

### BACKGROUND

Patent Document 1 discloses manufacturing a solar cell module by sequentially stacking and thermocompression-bonding solar cells, resin sheets forming an encapsulant, and protective members, to form a multilayer. Patent Document 1 further discloses illuminating the multilayer with light having a maximum spectral radiance between a wavelength of 1.2 µm to 12 µm, with a spectral radiance at a wavelength of 1.1 µm being 30% or less of the maximum spectral radiance, to heat the multilayer.

### CITATION LIST

### PATENT LITERATURE

Patent Document 1: JP 2008-117926 A

### SUMMARY

Weak adhesion between the solar cells and the encapsulants may cause exfoliation on their interfaces, causing disadvantages including impaired appearance and lowering of insulation. To strengthen the adhesion, the encapsulants may be heated at higher temperatures. However, excessively high temperatures of the encapsulant may, in turn, cause volatile components in the encapsulants to generate gas bubbles, making the impaired appearance or lowering of insulation more noticeable.

In accordance with an aspect of the disclosure, a method for manufacturing a solar cell module includes a step of producing a multilayer by sequentially stacking and thermocompression-bonding a solar cell, an encapsulant, and a protective member; a heat treatment step of heating the entire multilayer and cooling the multilayer to a predetermined temperature after completion of the heating; and a light illumination step of illuminating the solar cell of the multilayer with light having a maximum peak wavelength of 1500 nm or less such that temperatures of the solar cell and the encapsulant forming the multilayer do not exceed respective maximum temperatures at least in the heat treatment step, to thereby heat the encapsulant by an increase in the temperature of the cell.

In accordance with another aspect of the disclosure, an apparatus for manufacturing a solar cell module includes a laminator configured to stack and thermocompression-bond a solar cell, an encapsulant, and a protective member to form a stack; a heating furnace configured to heat the entire multilayer; a cooler configured to cool the multilayer which has been heated in the heating furnace; a light source configured to illuminate the solar cell of the multilayer which has been cooled by the cooler with light having a maximum peak wavelength of 1500 nm or less; and a carrier configured to carry the multilayer.

According to one aspect of the present disclosure, a solar cell module having strong adhesion between solar cells and encapsulants can be provided. A solar cell module according to one aspect of the present disclosure has enhanced appearance and improved insulation properties, for example.

### BRIEF DESCRIPTION OF DRAWINGS

[FIG. 1]

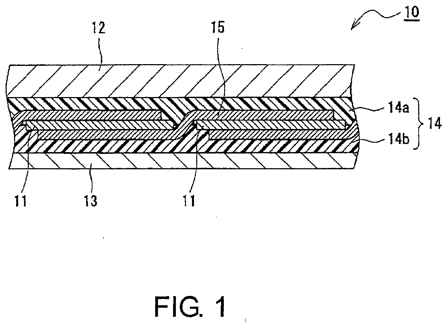

   FIG. 1 is a cross-sectional view of a solar cell module according to an example embodiment.
[FIG. 2]

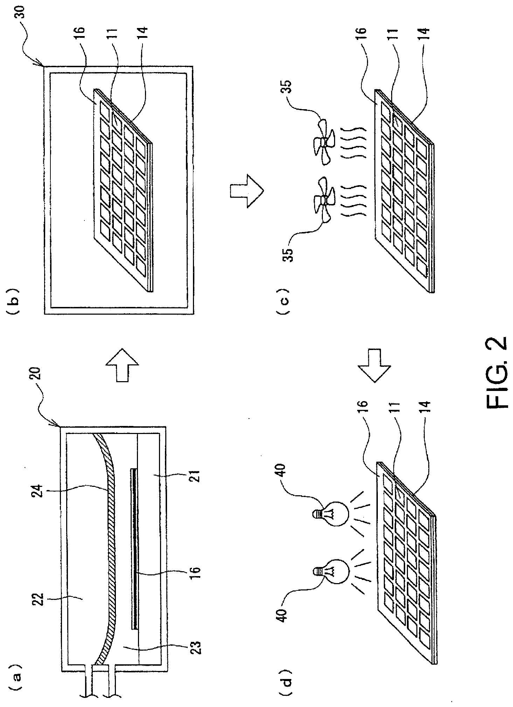

   FIG. 2 illustrates a manufacturing process for a solar cell module according to an example embodiment.
[FIG. 3]

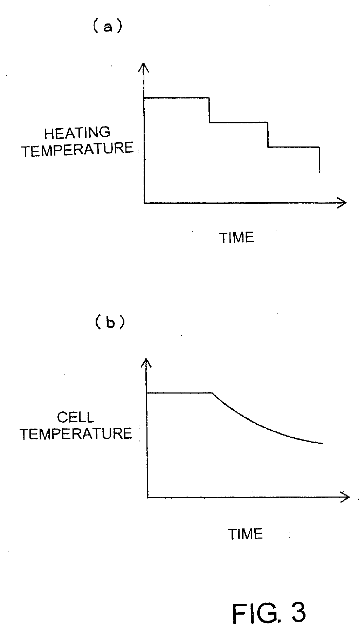

   FIG. 3 illustrates one example heat pattern in a heat treatment process illustrated in FIG. 2, and the temperature of a solar cell when this heat pattern is employed.
[FIG. 4]

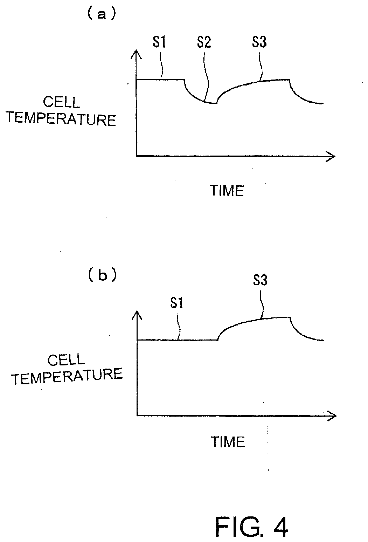

   FIG. 4 illustrates the temperature of a solar cell in the manufacturing process illustrated in FIG. 2.
[FIG. 5]

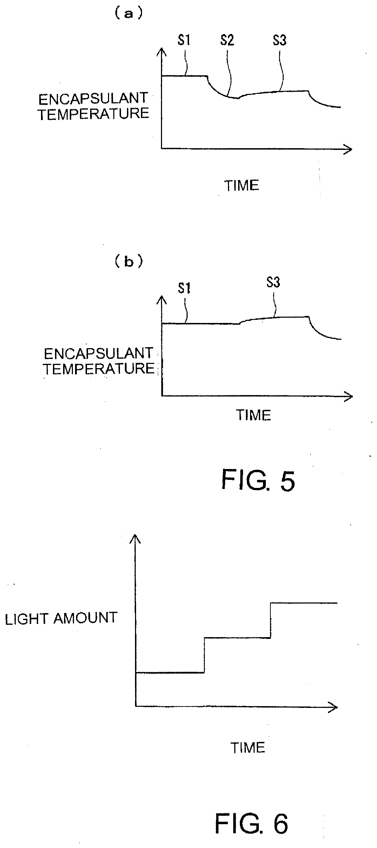

   FIG. 5 illustrates the temperatures of an encapsulant in the manufacturing process in FIG. 2.
[FIG. 6]
   FIG. 6 illustrates an example light illumination pattern in a light illumination step in FIG. 2.
[FIG. 7]

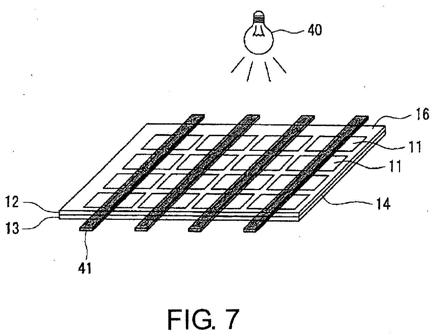

   FIG. 7 illustrates another example light illumination step.
[FIG. 8]

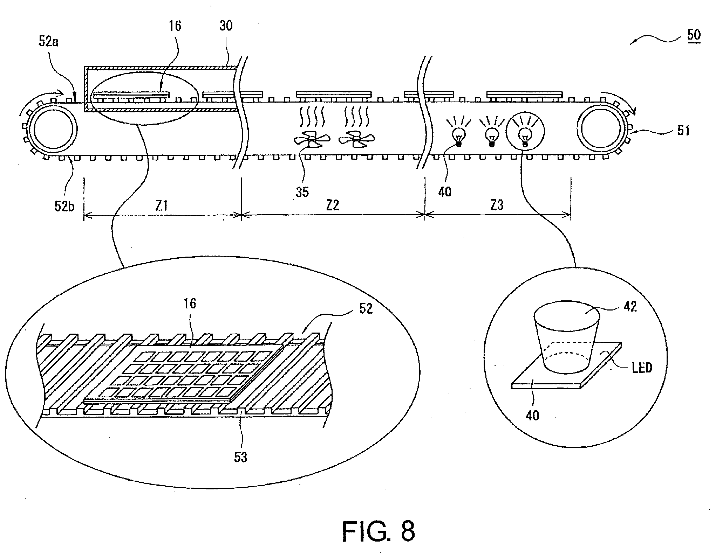

   FIG. 8 illustrates a manufacturing apparatus for a solar cell module (a laminator omitted) according to an example embodiment.
[FIG. 9]

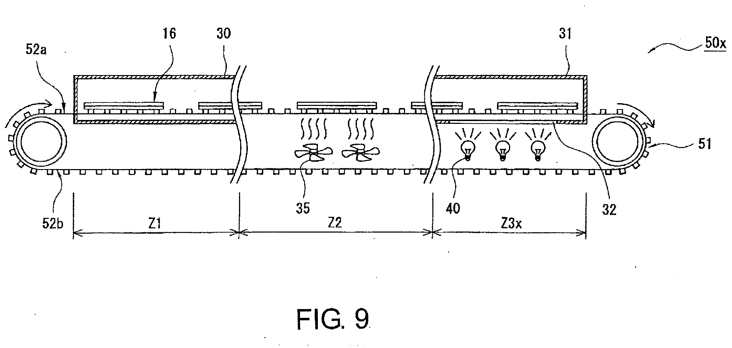

   FIG. 9 illustrates another example light illumination zone.
[FIG. 10]

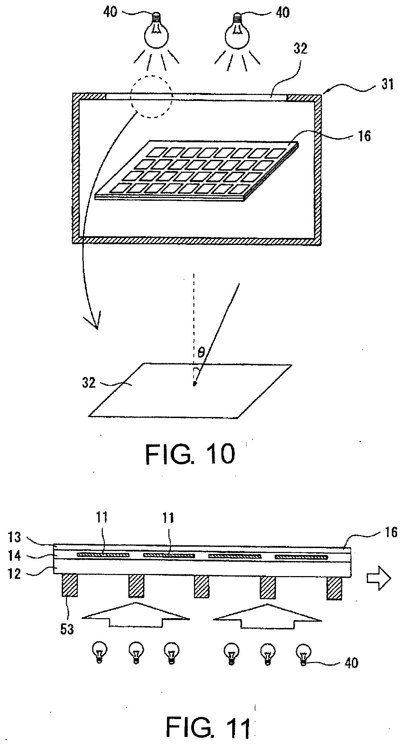

   FIG. 10 illustrates a heating furnace employed in the light illumination zone in FIG. 9.
[FIG. 11]
   FIG. 11 illustrates another example light illumination zone.
[FIG. 12]

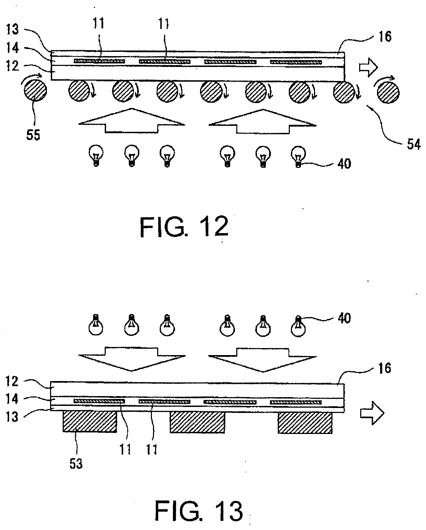

   FIG. 12 illustrates another example light illumination zone.
[FIG. 13]
   FIG. 13 illustrates another example light illumination zone.

### DESCRIPTION OF EMBODIMENTS

Example embodiments will be described in detail below with reference to the drawings. The drawings describe the embodiments schematically. For example, the dimensional ratios of components illustrated in the drawings may differ from those in actual products. The specific dimensional ratios should be determined in consideration of the following description.

FIG. 1 is a cross-sectional view of a solar cell module 10 according to an example embodiment. The solar cell module 10 includes a plurality of solar cells 11, a first protective member 12 disposed on light receiving sides of the solar cells 11, and a second protective member 13 disposed on back sides of the solar cells 11. The plurality of solar cells 11 are interposed between the first protective member 12 and the second protective member 13 and sealed by an encapsulant 14 filling a space between these protective members. The solar cell module 10 includes a plurality of strings made, for example, of adjacent solar cells 11 connected via a conductor 15. A string is formed of a plurality of solar cells 11 that are arranged in a line and serially connected with each other via the conductors 15.

The "light receiving side" of the solar cell module 10 and of the solar cell 11 refers to a surface which most of available sunlight (over 50% to 100%) enters, and the "back side" refers to a surface opposite the light receiving side. The terms "light receiving side" and "back side" are also used for other components including the protective members.

The solar cell 11 includes a photoelectric conversion unit that receives sunlight and generates carriers. The photoelectric conversion unit includes a light receiving side electrode on the light receiving side and a back side electrode on the back side (both not shown). In preferred embodiments, the back side electrode has a larger area than the light receiving side electrode. The structure of the solar cell 11 is not particularly limited, and the photoelectric conversion unit may include an electrode only on the back side.

The photoelectric conversion unit includes a semiconductor substrate of crystalline silicon (c - Si), gallium arsenide (GaAs), or indium phosphide(InP), for example, an amorphous semiconductor layer formed on the semiconductor substrate, and a transparent conductive layer formed on the amorphous semiconductor layer, for example. In a specific example structure, a p-type amorphous silicon layer and a transparent conductive layer are sequentially formed on the light receiving side of an n-type single crystal silicon substrate, and an n-type amorphous silicon layer and a transparent conductive layer are sequentially formed on the back side. A passivation layer such as an i-type amorphous silicon layer may be disposed between the n-type single crystal silicon substrate and the p-type amorphous silicon layer. A passivation layer may also be disposed similarly between the n-type single crystal silicon substrate and the n-type amorphous silicon layer. In preferred embodiments, the transparent conductive layer is formed of a transparent conductive oxide obtained by doping a metal oxide such as indium oxide (In₂O₃) or zinc oxide (ZnO) with tin (Sn) or antimony (Sb), for example.

The electrode is formed of a plurality of finger portions and a plurality of bus bar portions. The finger portions are thin linear electrodes formed on the transparent conductive layer, and the bus bar portions are formed on the transparent conductive layer for collecting carriers from the finger portions. In the present embodiment, three bus bar portions are formed on each side of the photoelectric conversion unit, and the conductors 15 are attached to the bus bar portions. The conductor 15 is connected to the light receiving side of one solar cell 11 and to the back side of another solar cell 11.

The first protective member 12 can be formed using a translucent member such as a glass substrate, a resin substrate, or a resin film, for example. In preferred embodiments, a glass substrate is used, among these members, in consideration of refractoriness, durability, and other properties. The thickness of the glass substrate is not particularly limited, but is preferably about 2 mm to about 6 mm.

The second protective member 13 may be formed using a transparent member as used for the first protective member 12 or using an opaque member. In preferred embodiments, a resin film (resin sheet), for example, is used for the second protective member 13. For the purpose of reducing water permeability, a layer of a metal such as aluminum or a layer of an inorganic compound such as silica may be formed on the resin film. The thickness of the resin film is not particularly limited, but is preferably about 100 µm to about 300 µm.

In preferred embodiments, the encapsulant 14 may include a first encapsulant 14a (hereinafter referred to as a "encapsulant 14a") disposed between the solar cells 11 and the first protective member 12 and a second encapsulant 14b (hereinafter referred to as a "encapsulant 14b") disposed between the solar cells 11 and the second protective member 13. As will be detailed below, the solar cell module 10 is manufactured through a lamination step using the encapsulants 14a and 14b in sheet form. The thickness of the encapsulant 14a or 14b is not particularly limited, but is preferably about 100 µm to about 1000 µm.

The encapsulant 14 is composed mainly (over 50% by weight) of a resin that is applicable to the lamination step, and contains this resin in the quantity of preferably 80% by weight or more, and more preferably 90% by weight or more. The encapsulant 14 may further contain, in addition to the resin, various additives such as an antioxidant, an ultraviolet absorption agent, a wavelength conversion material, or a coloring material. In preferred embodiments, the encapsulant 14 contains at least a coupling agent.

Examples of the resin that is suitable as the main component for the encapsulant 14 include, for example, olefin resins obtained by polymerizing at least one selected from α-olefins having a carbon number of 2 to 20 (for example, polyethylene, polypropylene, or a random or block copolymer of ethylene and another α-olefin), ester resins (for example, a polycondensate of polyol and polycarboxylic acid or an acid anhydride thereof), urethane resins (for example, a polyaddition product of polyisocyanate and an active hydrogen group-containing compound such as diol, polyol, dicarboxylic acid, polycarboxylic acid, polyamine, or polythiol), epoxy resins (for example, a ring-opening polymerization product of polyepoxide or a polyaddition product of polyepoxide and an active hydrogen group-containing compound such as those listed above), and copolymers of an α-olefin and vinyl carboxylate, an acrylic ester, or another vinyl monomer.

Among these components, an olefin resin (in particular, an ethylene-containing polymer) or a copolymer of an α-olefin and vinyl carboxylate is particularly preferred. Among copolymers of an α-olefin and vinyl carboxylate, an ethylene-vinyl acetate copolymer (EVA) is particularly preferred. In preferred embodiments, when an EVA is used, an organic peroxide such as benzoyl peroxide, dicumyl peroxide, or 2,5-dimethyl-2,5-di(t-butylperoxy)hexane is used as a crosslinking agent.

While the encapsulants 14a and 14b may be formed of the same material, to establish, for example, the tolerance to temperature cycles and the tolerance to high temperature and high humidity simultaneously, they may be formed of different materials. For example, a resin having a high crosslink density may be used for the encapsulant 14a and a resin having a low crosslink density or a non-crosslinkable resin may be used for the encapsulant 14b. The crosslink density of a resin can be evaluated by gel fraction; a resin having a higher gel fraction tends to have a higher crosslink density.

The coupling agent is contained at least in the encapsulant 14a, and is preferably also contained in the encapsulant 14b. The coupling agent enhances the adhesion between the solar cells 11 and the encapsulants 14, facilitating prevention of interface exfoliation. The coupling agent may be a silane coupling agent, a titanate coupling agent, or an aluminate coupling agent, for example, among which the silane coupling agent is particularly preferable. Examples of the silane coupling agent include, for example, vinyltriethoxysilane, γ-glycidoxypropyltrimethoxysilane, and γ-metacryloxypropyltrimethoxysilane.

With reference to FIG. 2, and with reference to FIG. 3 to FIG. 7, as required, an example manufacturing process for the solar cell module 10 having the structure described above will be described in detail hereinafter.

As illustrated in FIG. 2(a), a manufacturing process for the solar cell module 10 includes a step of producing a multilayer 16 (hereinafter referred to as a "lamination step"). As illustrated in FIG. 2(b) to FIG. 2(d), the manufacturing process for the solar cell module 10 further includes a heat treatment step and a light illumination step. In preferred embodiments, the manufacturing process for the solar cell module 10 includes the lamination step, the heat treatment step, and the light illumination step in this order. The heat treatment step includes a heating step for heating the multilayer 16 and a cooling step for cooling the multilayer 16 which has been heated. More specifically, the temperature of the multilayer 16 increased in the heating step is decreased in the cooling step before execution of the light illumination step. Cooling of the multilayer 16 before the light illumination step prevents an excessive temperature rise in the solar cells 11 and the encapsulants 14 during the light illumination step, thereby preventing deterioration of performance of the solar cell module 10 (such as impaired appearance or lowered insulation, for example). During the cooling step, a whole multilayer 16 including the solar cells 11 and the encapsulants 14 is cooled to a predetermined temperature, so as to prevent the temperature increase of the solar cells 11 and the encapsulants 14 during the light illumination step beyond the respective maximum temperatures in the heat treatment step. This will be described in detail below.

In the lamination step, strings of solar cells 11, a first protective member 12, a second protective member 13, and encapsulants 14a and 14b in sheet form (hereinafter referred to as "encapsulant sheets 14a and 14b") are stacked and thermocompression-bonded together to produce a multilayer 16. The strings of solar cells 11 can be produced by conventional methods. The lamination step is performed using a laminator 20. The laminator 20 includes, for example, a heater 21 and a vacuum chamber separated into two vacuum chambers (an upper vacuum chamber 22 and a lower vacuum chamber 23). The vacuum chamber is segmented by elastic rubber 24.

In the lamination step, the first protective member 12, the encapsulant sheet 14a, the solar cells 11, the encapsulant sheet 14b, and the second protective member 13 are stacked in this order and placed on the heater 21. Subsequently, the stacked members are heated by the heater 21 while the upper vacuum chamber 22 and the lower vacuum chamber 23 are being evacuated. Then, on stopping evacuation of the upper vacuum chamber 22 and introducing air into the upper vacuum chamber 22, the rubber 24 stretches toward the heater 21 to press down the stacked members. Heating the stacked members at about 150°C in this state softens (melts) the resin forming the encapsulant sheets 14a and 14b. If the resin is crosslinkable, the heating facilitates a crosslinking reaction to form a multilayer 16.

In the heating step, the whole multilayer 16 produced in the lamination step is heated to enhance adhesion between the solar cells 11 and the encapsulants 14, and also to facilitate a crosslinking reaction of the resin forming the encapsulants 14 to thereby increase the crosslink density. In preferred embodiments, the heating step is performed using a heating furnace 30. The heating furnace 30 is not particularly limited, and any heating furnace that can accommodate the multilayer 16, such as a resistance heating furnace, may be used. The temperature within the heating furnace 30, that is, the heating temperature during the heating step, is preferably 145°C to 180°C, and more preferably 150°C to 170°C. In consideration of facilitation of the crosslinking reaction, productivity, and other performances, the length of time of the heating step is preferably about 5 minutes to about 60 minutes, and more preferably about 10 minutes to about 45 minutes. The maximum temperature of the multilayer 16 during the heating step is the same as the highest temperature within the heating furnace 30.

As illustrated in FIG. 3(a), during the heat treatment step, the heating temperature may be decreased over time. More specifically, the temperature of the multilayer 16 can be decreased over time by decreasing the temperature within the heating furnace 30 gradually or stepwise, as shown in FIG. 3(b). When the heating furnace 30 is placed along a carrying path of the multilayer 16, the temperature on the upstream side can be set to high temperatures (170°C, for example) and the temperature on the downstream side can be set to low temperatures (130°C, for example). Such a heat pattern can be used to decrease the temperature of the multilayer 16 over time, thereby contributing to prevention of overheating of the solar cells 11 and the encapsulants 14 during the light illumination step.

In the cooling step, the multilayer 16 having been heated in the heating step is cooled prior to the light illumination step. In the cooling step, the multilayer 16 taken out of the heating furnace 30 may be placed in an ambient temperature atmosphere and allowed to cool naturally. In view of productivity, however, the multilayer 16 is cooled positively by using coolers 35. Although the cooler 35 may include a contact type cooling mechanism that comes in contact with the multilayer 16 for cooling, in preferred embodiments, the cooler 35 includes a non-contact type cooling mechanism. Preferable examples of the cooler 35 may include an air blower.

As described above, in the cooling step, the multilayer 16 is cooled to a predetermined temperature to inhibit the temperatures of the solar cells 11 and the encapsulants 14 in the following light illumination step from exceeding the respective maximum temperatures in the heating step. More specifically, in preferred embodiments, the multilayer 16 is cooled until the temperatures of the solar cells 11 and the encapsulants 14 forming the multilayer 16 are decreased to 140°C or lower. During the cooling step, in view of prevention of overheating in the light illumination step, productivity, and other properties, the temperature of the encapsulants 14 is decreased to a range of 50°C to 140°C, for example, and more preferably to a range of 60°C to 130°C. When the solar cells 11 and the encapsulants 14 are cooled to 140°C or lower, the temperatures of the respective protective members forming the respective surfaces of the multilayer 16 are also 140°C or lower.

FIG. 4(a) shows the temperature of the solar cell 11 (cell temperature) in the heating step S1, the cooling step S2, and the light illumination step S3. FIG. 4(b) shows, for comparison purposes, the cell temperature when the cooling step S2 is not performed. As shown in FIG. 4(a), although the temperature of the solar cell 11 increases in the light illumination step S3 which will be described below, an excessive temperature rise in the solar cell 11 can be avoided during the light illumination step S3 by performing the cooling step S2 to lower the cell temperature increased during the heating step S 1. More specifically, cooling conditions in the cooling step S2 are set in consideration of the increase in the cell temperature during the light illumination step S3, and the light illumination step S3 terminates before the cell temperature reaches the maximum temperature of the cell in the heating step S1. In contrast, when the cooling step S2 is not performed as shown in FIG. 4(b), the cell temperature during the light illumination step S3 may exceed the maximum temperature of the cell in the heating step S1.

FIG. 5 shows, in place of the cell temperature shown in FIG. 4, the temperature of the encapsulants 14 (encapsulant temperature) during each step. As will be detailed below, as the encapsulants 14 are heated by heat transferred from the solar cells 11 during the light illumination step S3, the degree of the temperature rise in the encapsulants 14 during the light illumination step S3 is smaller than that in the solar cells 11. However, if the cooling step S2 is not performed, the encapsulant temperature during the light illumination S3 would exceed the maximum temperature of the encapsulants 14 in the heating step S1, as shown in FIG. 5(b). As shown in FIG. 5(a), such an excessive temperature rise in the encapsulants 14 during the light illumination step S3 can be prevented by performing the cooling step S2.

In the light illumination step, the solar cells 11 of the multilayer 16 are illuminated with light having a maximum peak wavelength of 1500 nm or less (hereinafter referred to as "specific light") and an increase in the temperature in the cells is used to heat the encapsulants 14. Specifically, in the light illumination step, the solar cells 11 absorb the specific light to indirectly heat the encapsulants 14 using the temperature rise in the cells.

The light illumination step is performed such that the temperatures of the solar cells 11 and the encapsulants 14 forming the multilayer 16 do not exceed the respective maximum temperatures in the heating step. According to the present embodiment, because the temperature of the multilayer 16 which has been increased in the heating step is lowered by the cooling step, the temperatures of the solar cells 11 and the encapsulants 14, even if increased during the light illumination step, would not reach the maximum temperature in the heating step. The light illumination step may be performed in the atmosphere at room temperature or within a heating furnace which is set at a temperature lower than the heating temperature in the heating step. In preferred embodiments, the maximum temperature within the heating furnace is 110°C or lower.

In the light illumination step, the heat of the solar cells 11 which has absorbed the specific light is transferred to the encapsulants 14 to locally heat the encapsulants 14 near the interfaces between the encapsulants 14 and the solar cells 11. This local heating of the encapsulants 14 enhances adhesion between the solar cells 11 and the encapsulants 14 while preventing generation of gas bubbles in the encapsulants 14. Further, the cooling step prevents the excessive temperature rise in the solar cells 11 and the encapsulants 14 during the light illumination step.

In the light illumination step, a light source capable of radiating the specific light is used. For the purpose of selectively heating the solar cells 11 and preventing deterioration of the encapsulants 14 and other members, the maximum peak wavelength of the specific light is preferably about 400 nm to about 1500 nm, and more preferably about 400 nm to about 1200 nm. Light having the maximum peak wavelength in those ranges is easily absorbed by the solar cells 11 and easily passes through the encapsulants 14, and can therefore selectively heat only the solar cells 11.

In the light illumination step, a light source with the illumination intensity of light having a wavelength of 1500 nm or greater being preferably 1% or less of the maximum peak, and more preferably 0.5% or less of the maximum peak, is used for light illumination. Further, in particularly preferred embodiments, the ratio of light having a wavelength of 1200 nm or less in the light (specific light) radiated from the light source is 99% or greater. Because light having a wavelength of over 1200 nm, or in particular, over 1500 nm, is easily absorbed by the encapsulants 14 (olefin resin), in preferred embodiments, the specific light radiated onto the multilayer 16 contains a higher ratio of light having a wavelength of 1200 nm or less and a lower ratio of light having a wavelength of over 1200 nm or, in particular, over 1500 nm.

The light source 40 used in the light illumination step is not particularly limited and any light sources that can radiate the specific light, such as a xenon lamp, a halogen lamp, or an LED, may be used. Although FIG. 2 and other drawings illustrate the light sources 40 in a light bulb shape, as described above, these drawings are only schematic drawings, which do not limit the light sources shapes. As shown in FIG. 8, which will be described below, an LED substrate may be used as a light source.

The light illumination step increases the temperatures of the solar cells 11 and of the encapsulants 14 near the interfaces with the solar cells 11 to temperatures higher than the temperatures of the remaining portions of the multilayer 16 by, for example, about 5°C to about 120°C, and preferably about 30°C to about 80°C. However, the maximum temperatures of the solar cells 11 and the encapsulants 14 during the light illumination step must be lower than their maximum temperatures during the heating step, and are preferably about 90°C to about 170°C, and more preferably about 120°C to about 160°C. The maximum temperatures of the solar cells 11 and other members during the light illumination step can be regulated to be lower by adjusting the temperature of the multilayer 16 to be lower in the cooling step, for example.

Although both sides of the multilayer 16 may be illuminated with the specific light, in preferred embodiments, one side of the multilayer 16 is illuminated with the specific light for productivity and other reasons. When the second protective member 13 includes a metal layer or when the encapsulant 14b contains a coloring material such as titanium oxide, the first protective member 12 side is illuminated with the specific light.

As illustrated in FIG. 6, the amount of the specific light to be radiated (hereinafter referred to as a "light amount") may be increased over time. For example, a plurality of light sources are disposed along the carrying path of the multilayer 16 and the outputs of the light sources are increased from upstream toward downstream to thereby increase the light amount stepwise. Alternatively, a single light source may be used to increase the output gradually or stepwise. Also, the number of light sources, processing time, and other conditions may be changed to adjust the light amount.

As illustrated in FIG. 7, with highly thermal conductive members 41 being arranged on the first protective member 12, the specific light may be radiated onto the multilayer 16 from the first protective member 12 side. The highly thermal conductive members 41 are arranged on the first protective member 12 to each extend across a plurality of solar cells 11, partially covering each of the solar cells. More specifically, in the example illustrated in FIG. 7, the solar cells 11 and the highly thermal conductive members 41 overlap each other in the thickness direction of the multilayer 16.

The highly thermal conductive members 41 have a higher thermal conductivity than the protective members and the encapsulants 14, and help reduce variation of the temperature rise of each solar cell 11 due to light illumination. Specifically, heat is transferred from the highly thermal conductive members 41, which have been illuminated with light to have an increased temperature, to the plurality of solar cells 11 via the protective members, for example. This structure can reduce the temperature variation among the solar cells 11 even when different amounts of light enter the solar cells 11, thereby unifying the adhesion strength between the solar cells 11 and the encapsulants 14.

Metal plates, metal bars, metal wires, or metal meshes, for example, may be used as the highly thermal conductive members 41. The highly thermal conductive member 41 has, for example, a width that is slightly greater than the width of an interval between the solar cells 11 and a length corresponding to a total length of a plurality of solar cells 11, and may be placed over the intervals between adjacent solar cells 11. This structure can make the temperatures of the solar cells 11 uniform while avoiding a decrease in the amount of light entering the solar cells 11. The highly thermal conductive members 41 may be arranged to cover portions of all the solar cells 11, or may be arranged to cover only portions of the solar cells 11 with significant variations in the amounts of incident light. Also, supporting portions of a carrier, which will be described below, may be used as the highly thermal conductive member 41.

After completion of the above steps, a step of trimming the multilayer 16, a step of attaching a frame and terminal boxes, and other steps are further performed as required, and the solar cell module 10 is manufactured.

As described above, the above manufacturing process can enhance the adhesion between the solar cells 11 and the encapsulants 14 while avoiding excessive temperature rise in the whole encapsulants 14. The above manufacturing process can therefore reduce separations of the solar cells 11 and the encapsulants 14 at their interfaces or prevent impaired appearance and lowered insulation of the solar cells 11 and the encapsulants 14 caused by overheating thereof. As a result, the solar cell module 10 with high reliability can be provided. The above manufacturing process is particularly suitable when the encapsulants 14 containing a coupling agent are used, because the reaction between surfaces of the solar cells 11 and the coupling agent can be significantly accelerated.

Referring to FIG. 8 to FIG. 13, an apparatus 50 for manufacturing a solar cell module (hereinafter referred to as a "manufacturing apparatus 50") according to an example embodiment will be described in detail.

FIG. 8 illustrates the manufacturing apparatus 50. The manufacturing apparatus 50 includes a laminator 20 (see FIG. 2), a heating furnace 30, a cooler 35, light sources 40, and a carrier for carrying a multilayer 16. The laminator 20 produces a multilayer 16 by sequentially stacking and thermocompression-bonding solar cells 11, encapsulants 14, and protective members. Preferable carriers include a conveyor capable of continuously transporting the multilayers 16. In this embodiment, a belt conveyor 51 is used.

The belt conveyor 51 includes support portions 53 on which the multilayers 16 are placed. The support portions 53 are a plurality of metal bars or metal plates arranged at predetermined intervals in the longitudinal direction of a seamless belt 52, for example, and end portions of the support portions 53 are coupled together to form the belt 52. The belt conveyor 51 carries the multilayers 16 produced in the laminator 20 into a heating furnace 30 (heating zone Z1), and then carries the multilayers 16 sequentially to a cooling zone Z2 where the coolers 35 are disposed and to a light illumination zone Z3 where the light sources 40 are disposed. As such, the heating furnace 30, the coolers 35, and the light sources 40 are sequentially disposed in this order from the upstream side of the belt conveyor 51. In the example illustrated in FIG. 8, no heating furnace is disposed in the light illumination zone Z3, and therefore the light illumination step is performed in the atmosphere at room temperature.

In preferred embodiments, when a first protective member 12 is a glass substrate and a second protective member 13 is a resin film, the multilayers 16 are placed on the belt conveyor 51 with the glass substrate facing toward the support portions 53. In preferred embodiments, this arrangement is employed because a glass substrate is less likely to be thermally deformed than a resin film. If the resin film transmits specific light, the specific light can enter the multilayer 16 from both the glass substrate side and the resin film side (can be incident from both sides). Also, if the protective members are glass substrates, the specific light can enter from both sides. If the resin film hardly or never transmits the specific light, light illumination is performed from the glass substrate side.

The heating furnace 30 heats the entire multilayers 16. The heating furnace 30 can include a resistor heating furnace. In preferred embodiments, the heating furnace 30 heats the multilayer 16 to a temperature range of 145°C to 180°C. In preferred embodiments, the temperature inside the heating furnace 30 is preferably 120°C to 180°C, and more preferably 150°C to 170°C. In the example illustrated in FIG. 8, the heating furnace 30 is disposed along the conveyor, that is, along the carrying path of the multilayers 16. The heating temperature of the heating furnace 30 may be set lower toward the downstream side of the conveyor. For example, the heating temperature may be set to 170°C on the upstream side of the conveyor and set to 150°C on the downstream side. The time required for the multilayers 16 to pass through the heating furnace 30 is preferably 5 to 60 minutes, and more preferably 10 to 45 minutes. The temperature of the multilayer 16 (the solar cells 11 and the encapsulants 14) carried out of the heating zone Z1 is 145°C to 180°C, for example.

The coolers 35 cool the multilayers 16 that have been heated by the heating furnace 30. In preferred embodiments, the coolers 35 include air blowers. In the example illustrated in FIG. 8, a plurality of air blowers are arranged along the carrying path of the multilayers 16. The coolers 35 can be disposed between a carrier section 52a and a return section 52b of a belt 52. The carrier section 52a is a section of the belt on which the multilayers 16 are placed and carried, and the return section 52b is a section that runs along the back of the carrier section 52a. In preferred embodiments, the coolers 35 cool the multilayers 16 until the temperatures of the solar cells 11 and the encapsulants 14 forming the multilayers 16 are decreased to 140°C or lower. The temperature of the multilayer 16 carried out of the cooling zone Z2 is 50°C to 140°C, for example.

The light sources 40 radiate the specific light to the solar cells 11 of the multilayer 16 which has been cooled by the coolers 35. By illuminating the solar cells 11 of the multilayer 16 with the specific light emitted from the light sources 40, the temperature of the cells increases to locally heat the encapsulants 14 near the interfaces with the cells. Examples of the light source 40 include a xenon lamp, a halogen lamp, a metal halide lamp, or LEDs, for example. In the example illustrated in FIG. 8, a plurality of light sources 40 are arranged along the flow direction of the belt 52. The light sources 40 may be identical or may have different outputs, for example. In one example, a light source 40 with higher power may be disposed downstream of the belt conveyor 51 compared to a light source 40 disposed upstream, to increase the amount of light radiated to the multilayers 16 as more time elapses after the heating process performed by the heating furnace 30.

The light sources 40 are disposed between the carrier section 52a and the return section 52b of the belt 52 to radiate light to the multilayers 16 through intervals between the supporting portions 53. More specifically, the light sources 40 are disposed at positions in a space formed by the belt conveyor 51 where the light sources 40 can emit light to the multilayers 16 through between the supporting portions 53. The light sources 40 disposed at such positions can be used for more efficient light illumination compared, for example, to light sources 40 disposed below the belt conveyor 51 (below the return portion 52b).

In preferred embodiments, the light sources 40 are LEDs, for example. The light sources 40 may be LEDs that radiate light having a wavelength of 1500 nm or greater with illumination intensity being preferably 1% or less of the maximum peak, and more preferably 0.5% or less of the maximum peak. In particularly preferred embodiments, light (specific light) emitted from the LEDs contains light having a wavelength of 1200 nm or less at a ratio of 99% or greater. Examples of such LEDs include LEDs having a COB (chip-on-board) structure. To focus light radiated from the light sources 40 such as LEDs onto target illumination positions, lenses 42 may be provided between the light sources 40 and the multilayers 16. The lenses 42 may be made of glass, resin, or metal.

A manufacturing apparatus 50x illustrated in FIG. 9 includes a heating furnace 31 disposed in a light illumination zone Z3x. The temperature within the heating furnace 31 is set to a lower temperature than the temperature within the heating furnace 30 in the heating zone Z, and is preferably set to 140°C or less. In preferred embodiments, light sources 40 are disposed outside the heating furnace 31 to illuminate the multilayers 16 within the heating furnace 31 with the specific light through a translucent member 32. The light sources 40 disposed at such locations can have an extended life compared to the light sources 40 disposed within the heating furnace.

As illustrated in FIG. 10, at least a portion of a wall of the heating furnace 31 is formed of a translucent member 32 that transmits the specific light. Examples of the translucent member 32 include glass or a resin sheet that transmits the specific light. In preferred embodiments, to enable efficient light illumination, a high ratio of the specific light radiated from the light sources 40, or specifically 50% or more of the entire radiated light, enters the glass at an angle of incidence θ of 60° or less.

In the example illustrated in FIG. 11, the support portions 53 of the belt conveyor 51 are located on ends of the multilayer 16. Further, the support portions 53 are located at positions corresponding to the intervals between the solar cells 11 of the multilayer 16. Therefore, the solar cells 11 and the supporting portions 53 do not substantially overlap each other in the thickness direction of the multilayer 16. In other words, in the example illustrated in FIG. 11, the support portions 53 are disposed at intervals corresponding to the intervals between the solar cells 11, and the multilayers 16 are placed on the belt conveyor 51 such that the supporting portions 53 are located at positions corresponding to the intervals. Unless carrying performance or other properties are impaired, the support portions 53 may be disposed either on the ends of the multilayer 16 or at positions corresponding to the intervals between the solar cells 11. This configuration can reduce or eliminate the shading loss caused by the support portions 53.

In the example illustrated in FIG. 12, a roller conveyor 54 including a plurality of carrying rollers 55 is used as a carrier. The carrying rollers 55 serve as support portions on which the multilayers 16 are placed and carried. The light sources 40 are disposed on the backside of the roller conveyor 54, or in other words, below the carrying rollers 55, to illuminate the multilayers 16 with the specific light through between the carrying rollers 55. The positions of the carrying rollers 55 of the roller conveyor 54 are fixed, and some of the carrying rollers 55, for example, are driven to rotate for carrying the multilayers 16. As such, portions of the multilayers 16 shaded by the carrying rollers 55 vary, so that the solar cells 11 of the multilayers 16 can be uniformly illuminated with the specific light.

In the example illustrated in FIG. 13, the multilayer 16 is carried with the second protective member 13 (resin film) facing the support portions 53. In other words, the belt conveyor 51 carries the multilayer 16 with the first protective member 12 (glass substrate) facing upward. With this configuration, the multilayer 16 is illuminated preferably from the glass substrate side and therefore the light sources 40 are disposed above the belt conveyor 51.

The support portions of the carrier may also be composed of translucent members such as a glass or resin that transmits the specific light. The support portions, if made of metal, may also be used as the highly thermal conductive member as described above.

While, in the above embodiments, the coolers 35 are disposed in the cooling zone Z2, the coolers 35 may be eliminated. In this configuration, the multilayers 16 are left to cool in the cooling zone Z2. It is also possible to decrease the heating temperature over time in the heating zone Z1 to lower the temperature of the multilayers 16, and to subsequently perform the light illumination step such that the temperatures of the solar cells 11 and the encapsulants 14 do not exceed the respective maximum temperatures in the heating step. In preferred embodiments, however, in consideration of productivity and other properties, the cooling step capable of decreasing the temperature of the multilayers 16 immediately is performed prior to the light illumination step.

### REFERENCE SIGNS LIST

10 solar cell module, 11 solar cell, 12 first protective member, 13 second protective member, 14 encapsulant, 14a first encapsulant, 14b second encapsulant, 15 conductor, 16 multilayer, 20 laminator, 21 heater, 22 upper vacuum chamber, 23 lower vacuum chamber, 24 rubber, 30, 31 heating furnace, 32 translucent member, 35 cooler, 40 light source, 41 highly thermal conductive member, 42 lens, 50 solar cell module manufacturing apparatus, 51 belt conveyor, 52 belt, 52a carrier section, 52b return section, 53 support portion, 54 roller conveyor, 55 carrying roller, Z1 heating zone, Z2 cooling zone, Z3, Z3x light illumination zone.

## Claims

1. A method for manufacturing a solar cell module, the method comprising:
a step of producing a multilayer by sequentially stacking and thermocompression-bonding a solar cell, an encapsulant, and a protective member;
a heat treatment step of heating the entire multilayer and cooling the multilayer to a predetermined temperature after completion of the heating; and
a light illumination step of illuminating the solar cell of the multilayer with light having a maximum peak wavelength of 1500 nm or less such that temperatures of the solar cell and the encapsulant forming the multilayer do not exceed respective maximum temperatures at least in the heat treatment step, to thereby heat the encapsulant by an increase in the temperature of the cell.

2. The method for manufacturing a solar cell module according to claim 1, wherein
the heat treatment step comprises:
a heating step of heating the entire multilayer; and
a cooling step of cooling the multilayer which has been heated in the heating step.

3. The method for manufacturing a solar cell module according to claim 2, wherein
the heating step comprises heating the multilayer to a temperature range of 145°C to 180°C, and
the cooling step comprises cooling the multilayer until the temperatures of the solar cell and the encapsulant forming the multilayer are decreased to 140°C or less.

4. The method for manufacturing a solar cell module according to claim 1, wherein
the heat treatment step comprises reducing a heating temperature over time.

5. The method for manufacturing a solar cell module according to any one of claims 1 through 4, wherein
the encapsulant comprises a coupling agent.

6. An apparatus for manufacturing a solar cell module, the apparatus comprising:
a laminator configured to stack and thermocompression-bond a solar cell, an encapsulant, and a protective member to form a multilayer;
a heating furnace configured to heat the entire multilayer;
a cooler configured to cool the multilayer which has been heated in the heating furnace;
a light source configured to illuminate the solar cell of the multilayer which has been cooled by the cooler with light having a maximum peak wavelength of 1500 nm or less; and
a carrier configured to carry the multilayer.

7. The apparatus for manufacturing a solar cell module according to claim 6, wherein
the heating furnace is configured to heat the multilayer to a range of temperatures from 145°C to 180°C, and
the cooler is configured to cool the multilayer until temperatures of the solar cell and the encapsulant forming the multilayer are reduced to 140°C or less.

8. The apparatus for manufacturing a solar cell module according to claim 6 or 7, wherein
the carrier is a conveyor, and
the heating furnace is disposed along the conveyor, and a heating temperature is set to be lower toward a downstream side of the conveyor.

9. The apparatus for manufacturing a solar cell module according to any one of claims 6 to 8, wherein
the light source is an LED capable of emitting light having a wavelength of 1500 nm or greater with illumination intensity being 1 % or less of a maximum peak and containing light having a wavelength of 1200 nm or less at a ratio of 99% or greater.
